# EUROPEAN PATENT APPLICATION

(11) **EP 1 441 543 A2**
(43) Date of publication of application: **28.07.2004**
(21) Application number: 04001095.1
(22) Date of filing: 20.01.2004
(51) Int. Cl.: H04N 13/00

(54) **Three-dimensional image display device**

(30) Priority: 24.01.2003 JP 2003015931
(71) Applicant: Pioneer Corporation, Meguro-ku, Tokyo (JP)
(72) Inventor: Uchida, Yoshihiko c/o Corp.Research& Develop. Lab., Tsurugashima-shi, Saitama 350-2288 (JP); Hata, Takuya c/o Corp.Research& Develop. Lab., Tsurugashima-shi, Saitama 350-2288 (JP); Chuman, Takashi c/o Corp.Research& Develop. Lab., Tsurugashima-shi, Saitama 350-2288 (JP); Satoh, Hideo c/o Corp.Research& Develop. Lab., Tsurugashima-shi, Saitama 350-2288 (JP); Yoshizawa, Atsushi c/o Corp.Research&Develop. Lab., Tsurugashima-shi, Saitama 350-2288 (JP)
(74) Representative: Goddar, Heinz J., Dr.

(57) **Abstract**

A three-dimensional image display device in which at least two light-emitting display panels of a light permeable type are arranged in parallel in a normal direction of the front surface of the device, and a semi-transparent member is provided for reducing light emission from a light-emitting display panel located in the front to the other display panel located in the rear, preventing display images from blurring.

## Description

### BACKGROUND OF THE INVENTION

### 1. Field of the Invention

The present invention relates to a three-dimensional image display device using a plurality of light-emitting display panels of a light permeable type.

### 2. Description of the Related Art

As a light-emitting display panel of a light permeable type (hereinafter, referred to as permeable light-emitting display panel) including an emissive layer sandwiched between permeable films respectively provided on front and rear sides, exemplarily known is an electroluminescent display panel (hereinafter, referred to as EL display panel). The emissive layer of the EL display panel is made of an EL material utilizing an inorganic or organic thin film exhibiting electroluminescence (hereinafter, referred to as EL), being an optical phenomenon of light production by flowing current.

The permeable light-emitting display panel is applicable to a three-dimensional (hereinafter, simply referred to as 3D) image display device. For example, when an image is viewed on a display panel together with another same image on two permeable light-emitting display panels arranged one behind the other with some distance therebetween, the resulting image provided for a viewer looks as one merge image, not two images each having different depth. Based on this principle, there has been proposed a 3D image display device for changing the brightness (intensity) ratio between any two same images, so that the viewer can construct in his or her head the resulting merge image as a 3D image.

The 3D image display device does not require glasses specifically for 3D, and owing to its real and natural 3D display as compared with 3D image display devices of a conventional type, does not fatigue the viewer much.

The 3D image display device, however, causes the display images to appear blurred. This is because, of those two permeable light-emitting display panels, the one located front emits light not only to the front side of the device but also toward the rear display panel located behind. The light is scattered on the surface of the rear display panel, resultantly blurring the display images.

### SUMMARY OF THE INVENTION

In consideration of the above problems, an object of the present invention is to provide a three-dimensional image display device capable of preventing display images from blurring.

A three-dimensional image display device according to the present invention comprises at least two light-emitting display panels of a light permeable type which are arranged in parallel in a normal direction of a front surface of the device, wherein a semi-transparent member is provided for reducing light emission from a light-emitting display panel located in the front of the at least two light-emitting display panels to the other display panel located in the rear of the at least two light-emitting display panels.

### BRIEF DESCRIPTION OF THE DRAWINGS

Fig. 1 is a schematic cross-sectional view showing an embodiment of the present invention;
Fig. 2 is a cross-sectional view showing the specific structure of an organic layer of a 3D image display device in Fig. 1; and
Fig. 3 is a schematic view showing the operation of the 3D image display device in Fig. 1.

### DETAILED DESCRIPTION OF THE INVENTION

In the below, an embodiment of the present invention is described in detail by referring to the accompanying drawings.

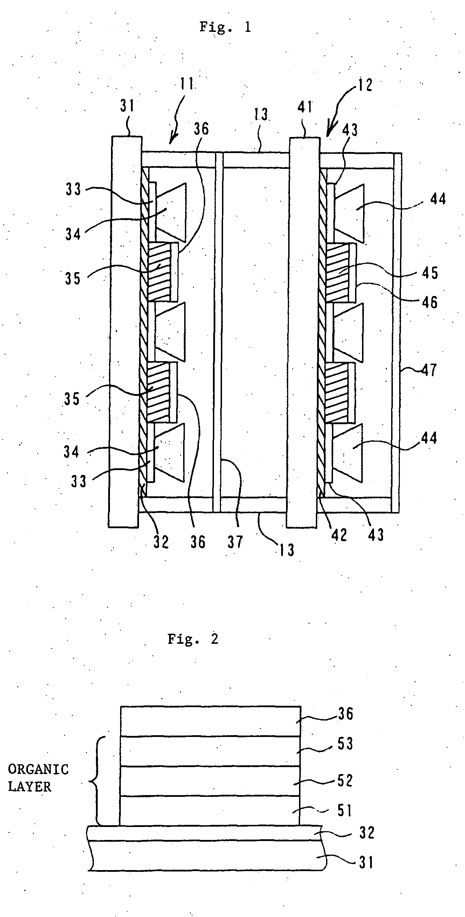

Fig. 1 shows an image display device according to the present invention. In the image display device, two permeable light-emitting display panels 11 and 12 are arranged in parallel in the direction of the normal to the front plane of the device. The display panel 11, which is located in the front of the device, and the display panel 12, which is located in the rear of the device and apart from display panel 11 by a predetermined distance, are formed as a body by sandwiching a tube spacer 13.

Each of the display panels 11 and 12 is structured by a plurality of organic EL elements arranged in a matrix. Specifically, in the front display panel 11, an anode layer 32 is formed on a plane opposite to the front surface of a transparent glass substrate 31, which constitutes the front of the device. On the anode layer 32, an organic layer 35 serving as the main component of the organic EL element and a cathode layer 36 stacked thereon are arranged in a matrix. The stacking parts of the organic layer 35 and the cathode layer 36 each correspond to a pixel of the display screen. Further, on the anode layer 32, an insulation layer 33 and a cathode diaphragm 34 are stacked together so as to define each pixel. The insulation layer 33 is formed to prevent current leak between pixels. The above portion formed on the transparent glass substrate 31 is protected by a transparent sealing can 37.

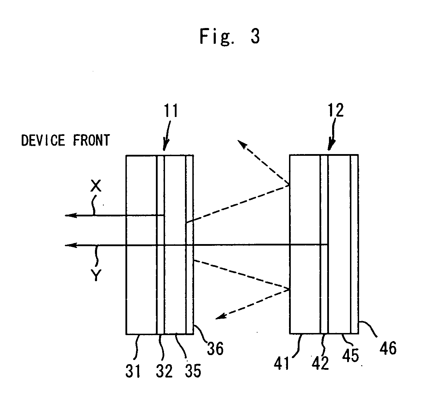

The organic layer 35 of the organic EL element is structured by stacking a hole transfer layer 51, an emissive layer 52, and an electron transport layer 53 in that order, as specifically shown in Fig. 2.

Similarly to the front display panel 11, the rear display panel 12 is provided with a transparent glass substrate 41, an anode layer 42, an insulation layer 43, a cathode diaphragm 44, an organic layer 45, a cathode layer 46, and a sealing can 47.

The two display panels 11 and 12 have the same number of pixels (both in the vertical and lateral directions), and the pixels of the display panel 11 correspond, in position, to those of the display panel 12.

The anode layers 32 and 42 of the front and rear display panels 11 and 12 are both transparent electrodes. The cathode layer 36 of the front display panel 11 is a half mirror made of a thin semi-transparent metal of about 20 Å. The cathode layer 46 of the rear display panel 12 is not necessarily transparent, and may be an electrode with 100% reflection.

In the image display device according to the present invention having the configuration as described above, the display panels 11 and 12 are individually driven by applying a voltage between the anode layer 32 and the cathode layer 36 of the front display panel 11, and another voltage between the anode layer 42 and the cathode layer 46 of the rear display panel 12 by a driver (not shown). By the driving, light emitted from the emissive layer 35 in the front display panel 11 reaches, the front on the viewer side as indicated by an arrow X of Fig. 3. Similarly, light emitted from the emissive layer 45 of the rear display panel 12 passes through the front display panel 11 and reaches the front on the viewer side as indicated by an arrow Y of Fig. 3. On the front, provided for the viewer is a single image as a result of merging two images displayed, respectively, on the display panels 11 and 12. The resulting image looks different in depth depending on the brightness ratio among the pixels, whereby the viewer can perceive the image as being 3D.

Since the cathode layer 36 of the front display panel 11 is semi-transparent, the cathode layer 36 reduces the amount of light emission from the emissive layer 35 of the front display panel 11 toward the display panel 12 therebehind. Therefore, light scattering on the surface of the rear display panel 12 does not occur as indicated by dotted lines of Fig. 3. In this manner, blurring is successfully prevented from occurring to 3D images when viewed from the front side.

By the semi-transparent cathode layer 36, the light emitted from the emissive layer 35 of the front display panel 11 toward the rear display panel 12 therebehind is reflected toward the front, whereby the brightness at the front is expected to increase.

In the case of displaying 3D images using the front and rear display panels as described in the above embodiment, it is desirable that the light intensities coming from these front and rear panels are equal on the front side of the front display panel, i.e., at the viewer's position. Assuming that the front and rear display panels have the same performance capabilities, when the front display panel has 100% transmittance, the light intensity from the front display panel to the viewer becomes almost the half of the light intensity provided from the rear display panel. This is because almost the half of the light emitted from the front display panel goes toward the rear display panel. To deal with that, the drive power of the front display panel has to be increased more than that of the rear display panel. As a result, the front display panel is put under heavy load, shortening the useful life thereof. In the present invention, by using the semi-transparent cathode layer 36 in the front display panel 11 as described in the above embodiment, the transmittance of the front display panel 11 toward the rear is reduced, while the reflectance is increased by the cathode layer 36. Assuming here that the transmittance of the semi-transparent cathode layer 36 is 75%, the reflectance thereof is 25%, and the front display panel 11 fully receives the light from the rear display panel 12, the light intensity A reaching the viewer by the light emitted from the front display panel 11 is calculated as follows:

A = light intensity directly reaching device front from emissive layer (50%) + light intensity reaching device front after reflected by semi-transparent cathode layer 36 (25%) = 75% of light intensity of front display panel 11 ...... (1).

On the other hand, the light intensity B reaching the viewer by the light emitted from the rear display panel 12 is represented as follows:

B = light intensity reaching device front from emissive layer via the front display panel 11 (75%) = 75% of light intensity of the rear display panel 12 ...... (2).

Therefore, if the EL elements of the front and rear display panels 11 and 12 have the same performance capabilities, these panels are driven under the same conditions such as drive power, resultantly equalizing their useful lives.

Here, in the above embodiment, the cathode layer of the front display panel 11 consists of a semi-transparent metal. This is not restrictive, and if the side of the front display panel 11 having the cathode layer is the device front, the cathode layer of the front display panel 11 is a transparent electrode, and the anode layer consists of a semi-transparent metal.

Further, in the above embodiment, the front display panel 11 itself has the semi-transparent member. However, surely such a semi-transparent member may be provided between the front and rear display panels 11 and 12 to achieve the same effects as described above.

Still further, the electrode layer supposed to be semi-transparent may be fully or partially semi-transparent.

Further, in the above embodiment, described are the organic EL elements utilizing thin films of the organic EL material. Alternatively, the present invention can be applied to a 3D image display device including light-emitting display panels of a light permeable type formed by inorganic EL elements utilizing thin films of an inorganic EL material.

As described in the foregoing, by providing a semi-transparent member capable of reducing light emission from a light-emitting display panel located in the front of at least two light-emitting display panels of a light permeable type to the other display panel located in the rear, blurring is successfully prevented from occurring to 3D images when viewed from the front side. The features disclosed in the foregoing description, in the claims and/or in the accompanying drawings may, both separately and in any combination thereof, be material for realising the invention in diverse forms thereof.

## Claims

1. A three-dimensional image display device in which at least two light-emitting display panels of a light permeable type are arranged in parallel in a normal direction of a front surface of the device,
wherein a semi-transparent member is provided for reducing light emission from a light-emitting display panel located in the front of said at least two light-emitting display panels to the other display panel located in the rear of said at least two light-emitting display panels.

2. The three-dimensional image display device according to claim 1, wherein each of said at least two light-emitting display panels has front and rear electrodes and an emissive layer sandwiched between the front and rear electrodes in the normal direction, and said semi-transparent member is the rear electrode of the light-emitting display panel located in the front.

3. The three-dimensional image display device according to claim 2, wherein the emissive layer is an electroluminescence element.
